# EUROPÄISCHE PATENTSCHRIFT

(11) **EP 4 147 543 B1**
(45) Veröffentlichungstag und Bekanntmachung des Hinweises auf die Patenterteilung: **10.04.2024**
(21) Anmeldenummer: 21754764.5
(22) Anmeldetag: 28.07.2021
(51) Int. Cl.: H05K 5/02, H05K 7/14, G01K 1/14

(54) **GEHÄUSE UND ELEKTRISCHES GERÄT**
HOUSING AND ELECTRICAL DEVICE
BOITIER ET APPAREIL ÉLECTRIQUE

(30) Priorität: 31.08.2020 EP 20193570
(43) Veröffentlichungstag der Anmeldung: 15.03.2023
(73) Patentinhaber: Siemens Aktiengesellschaft, 80333 München (DE)
(72) Erfinder: KÜRTEN, Bernd, 90587 Obermichelbach (DE); PFEFFERLEIN, Stefan, 90562 Heroldsberg (DE)
(74) Vertreter: Siemens Patent Attorneys
(86) Internationale Anmeldenummer: PCT/EP2021/071119
(87) Internationale Veröffentlichungsnummer: WO 2022/042984

(56) Entgegenhaltungen:
- EP-A1- 3 385 688
- WO-A1-2020/170000
- JP-A- 2016 206 024
- US-A1- 2020 098 667

## Beschreibung

Die Erfindung betrifft ein Gehäuse für ein elektrisches Gerät umfassend einen Gehäusekörper, welcher ein jeweiliges elektrisches Bauteil des elektrischen Gerätes zumindest teilweise einhaust, wobei der Gehäusekörper zumindest einen Auflagepunkt zur Auflage auf einer jeweiligen Platte aufweist, mit welcher das elektrische Bauteil verbunden ist, wobei das Gehäuse weiterhin zumindest einen Temperatursensor zur Erfassung der Temperatur der jeweiligen Platte aufweist, wobei der jeweilige Temperatursensor im Gehäusekörper im Bereich des jeweiligen Auflagepunktes angeordnet ist.

Weiterhin betrifft die Erfindung ein elektrisches Gerät umfassend zumindest ein elektrisches Bauteil, zumindest eine Platte, die jeweils mit dem jeweiligen elektrischen Bauteil verbunden ist, und zumindest ein derartiges Gehäuse, wobei der Gehäusekörper an dem jeweiligen Auflagepunkt auf der jeweiligen Platte aufliegt.

Derartige Vorrichtungen kommen in einer Vielzahl von Anwendungen in der Elektronik und der Leistungselektronik zum Einsatz.

Oftmals wird bei Applikationen mit Leistungselektronik eine Temperaturinformation der Bauteile bzw. Bauteilkomponenten benötigt. Hierzu muss ein Temperatursensor in der Nähe der Bauteile bzw. Bauteilkomponenten platziert werden, bspw., um über ein Modell die Temperatur der Bauteile bzw. Bauteilkomponenten unter Bezug der Temperaturinformation vom Temperatursensor zu errechnen.

Die Temperatursensoren werden bisher entweder auf dem Kühlkörper und damit verhältnismäßig weit von den Bauteilen bzw. Bauteilkomponenten entfernt platziert, was den Nachteil einer recht großen Ungenauigkeit hat, oder innerhalb des Moduls, bspw. Leistungsmoduls mit Leistungshalbleitern, auf einem dort vorhandenen Schaltungsträger. Letzteres hat den Nachteil, dass der Temperatursensor keine sichere elektrische Trennung zur restlichen Elektronik besitzt und diese gegebenenfalls durch andere Mittel wie Optokoppler erreicht werden muss. Außerdem kostet der Temperatursensor wertvollen Platz auf dem Schaltungsträger.

Aus der US 2020/098667 A1 ist ein Halbleitermodul bekannt, welches umfasst: ein Anschlussgehäuse aus einem Harz zum Unterbringen eines Halbleiterchips; und einen Kühlabschnitt mit einem Kältemittelzirkulationsabschnitt, durch den ein Kältemittel strömt, und einem Verbindungsabschnitt, der den Kältemittelzirkulationsabschnitt umgibt, wobei der Kältemittelzirkulationsabschnitt unter dem Anschlussgehäuse angeordnet ist und der Kühlabschnitt direkt oder indirekt in engem Kontakt mit dem Anschluss angeordnet ist Gehäuse an dem Verbindungsabschnitt, wobei das Anschlussgehäuse über dem Verbindungsabschnitt bereitgestellt ist und eine Seitenwand aufweist, die bereitgestellt ist, um den Halbleiterchip zu umgeben, wenn in einer Draufsicht gesehen, wobei ein Temperatursensor zum Erfassen einer Temperatur des Kältemittels an der Seitenwand bereitgestellt ist.

Eine Aufgabe der Erfindung ist es, ein verbessertes elektrisches Gerät bereitzustellen, welches insbesondere die genannten Nachteile überwindet.

Eine Lösung der Aufgabe ergibt sich durch ein Gehäuse der eingangs genannten Art dadurch, dass der Gehäusekörper weiterhin jeweils eine einpolige elektrische Leitung zu dem jeweiligen Temperatursensor aufweist.

Eine weitere Lösung der Aufgabe ergibt sich durch ein elektrisches Gerät der eingangs genannten Art dadurch, dass das elektrische Gerät das vorgeschlagene Gehäuse aufweist.

Das Gehäuse weist einen Gehäusekörper auf, der bspw. die Form einer Haube oder eines Bügels aufweisen kann und dabei insbesondere einen U-förmigen Querschnitt haben kann. Der Gehäusekörper kann auch schlauchförmig ausgestaltet sein und dabei einen rechteckigen Querschnitt aufweisen, wobei der Gehäusekörper optional lediglich eine Öffnung aufweist, wie bspw. ein Gefäß.

Der Gehäusekörper weist dabei zumindest einen Auflagepunkt zur Auflage auf der jeweiligen Platte auf, mit welcher das jeweilige elektrische Bauteil verbunden ist. Bspw. ist das jeweilige elektrische Bauteil auf der jeweiligen Platte angeordnet. Für das Beispiel einer haubenförmigen oder bügelförmigen Ausgestaltung des Gehäuses ist der jeweilige Auflagepunkt insbesondere dort, wo die Haube bzw. der Bügel die jeweilige Platte berührt.

Der Gehäusekörper ist derart ausgestaltet, dass er das jeweilige elektrische Bauteil zumindest teilweise einhaust. Bspw. ist der Gehäusekörper als Abdeckung oder Haube ausgebildet, die das jeweilige elektrische Bauteil zumindest teilweise abdeckt. Der Gehäusekörper kann auch als Gehäuserahmen ausgebildet sein. Insbesondere umschließen der Gehäusekörper und die jeweilige Platte das jeweilige elektrische Bauteil vollständig, zumindest in einer Ebene, welche das jeweilige elektrische Bauteil, den Gehäusekörper und die jeweilige Platte durchdringt. Der Gehäusekörper kann auch, wie erwähnt, wie ein Gefäß ausgestaltet sein, in welches das jeweilige elektrische Bauteil eingebracht wird, sodass das jeweilige elektrische Bauteil durch den Gehäusekörper ggf. zusammen mit der jeweiligen Platte, größtenteils umschlossen wird.

Weiterhin weist das Gehäuse zumindest einen Temperatursensor auf, mit welchem jeweils die Temperatur der jeweiligen Platte ermittelbar bzw. messbar ist. Vorzugsweise ist der jeweilige Temperatursensor somit in thermischem Kontakt mit der jeweiligen Platte. Der jeweilige Temperatursensor kann beispielsweise als Peltier-Element oder als Heißleiter bzw. NTC-Widerstand (NTC für englisch: Negative Temperature Coefficient) ausgestaltet sein.

Ferner ist der jeweilige Temperatursensor im Gehäusekörper im Bereich des jeweiligen Auflagepunktes angeordnet. Die Anordnung des jeweiligen Temperatursensors im Gehäusekörper bedeutet für das Beispiel eines bügelförmigen bzw. U-förmigen Gehäusekörpers, dass der jeweilige Temperatursensor in einem der beiden Arme des Bügels bzw. der U-Form integriert ist. Allgemeiner kann die Anordnung des jeweiligen Temperatursensors im Gehäusekörper bspw. so verstanden werden, dass der Gehäusekörper eine geometrische Gestalt mit Wänden oder Streben aufweist und der jeweilige Temperatursensor in einer der Wände oder Streben des Gehäusekörpers untergebracht bzw. in eine der Wände oder Streben integriert ist.

Die Anordnung des jeweiligen Temperatursensors im Bereich des jeweiligen Auflagepunktes kann bspw. dadurch erreicht werden, dass der jeweilige Temperatursensor den jeweiligen Auflagepunkt bzw. die jeweilige Platte direkt berührt bzw. direkt angrenzend angeordnet ist. Ferner kann eine derartige Anordnung auch dadurch erreicht werden, dass der jeweilige Temperatursensor in der Nachbarschaft zum jeweiligen Auflagepunkt angeordnet ist. Dies kann bspw. gegeben sein, wenn der Gehäusekörper eine Größe im Bereich von Zentimetern oder Dezimetern aufweist und der jeweilige Temperatursensor einen Abstand zum jeweiligen Auflagepunkt im Bereich von Millimetern, insbesondere wenigen Millimetern, einigen Zehntel oder Hundertstel Millimeter, hat.

Durch die Anordnung des jeweiligen Temperatursensors am bzw. nahe des jeweiligen Auflagepunktes und somit an bzw. nahe der jeweiligen Platte kann eine genauere Temperaturbestimmung der jeweiligen Platte und damit des jeweiligen elektrischen Bauteils erreicht werden. Dies ist wichtig, um eine Überhitzung des jeweiligen elektrischen Bauteils zu vermeiden, und kann somit die Lebensdauer des jeweiligen elektrischen Bauteils und somit das elektrischen Gerätes verlängern.

Je nach Ausgestaltung des jeweiligen Temperatursensors und des Bereiches zwischen dem jeweiligen Temperatursensor und der jeweiligen Platte kann auch mit vergleichsweise einfachen Mitteln eine sichere elektrische Trennung bzw. Isolation des jeweiligen Temperatursensors von der restlichen Elektronik des elektrischen Gerätes erreicht werden.

Der Gehäusekörper weist jeweils eine einpolige elektrische Leitung zu dem jeweiligen Temperatursensor auf. Dies bedeutet insb., dass der jeweilige Temperatursensor eine erste Anschlussleitung aufweist, die durch die jeweilige, einpolige elektrische Leitung verwirklicht ist. Vorzugsweise ist der jeweilige Temperatursensor in elektrischem Kontakt mit der jeweiligen Platte, sodass die zweite Anschlussleitung über die jeweilige Platte (und ggf. eine Erdung oder sonstige Leitung, die mit der jeweiligen Platte verbunden ist) verwirklicht wird. Die erste Anschlussleitung und die zweite Anschlages Leitung können dabei zusammen eine Signalleitung des jeweiligen Temperatursensors bilden. Dabei kann der jeweilige Temperatursensor die jeweilige Platte direkt berühren oder zwischen dem jeweiligen Temperatursensor und der jeweiligen Platte kann ein elektrisch leitendes Material, bspw. ein Lot oder dergleichen, angeordnet sein. Dieses elektrisch leitende Material ist dabei vorzugsweise gleichzeitig ein guter Wärmeleiter, d.h. ein Material mit einer Wärmeleitung von zumindest 40 W/(m-K), vorzugsweise größer 200 W/(m·K) oder 400 W/(m·K).

Diese Ausgestaltung der Erfindung wird vorzugsweise bei solchen elektrischen Geräten eingesetzt, bei welchen keine elektrische Trennung bzw. Isolation des jeweiligen Temperatursensors von der jeweiligen Platte bzw. dem jeweiligen elektrischen Bauteil erforderlich ist. Von Vorteil bei dieser Ausgestaltung der Erfindung ist, dass der jeweilige Temperatursensor sowohl platzsparend als auch sehr nahe bzw. im direkten thermischen Kontakt an bzw. mit der jeweiligen Platte bzw. dem jeweiligen elektrischen Bauteil angeordnet ist. Durch den letztgenannten Aspekt kann eine vergleichsweise genaue Temperaturerfassung der jeweiligen Platte bzw. des jeweiligen elektrischen Bauteils erreicht werden.

Bei einer vorteilhaften Ausgestaltung der Erfindung weist der Gehäusekörper, vorzugsweise zumindest im Bereich des jeweiligen Auflagepunkts, ein elektrisch isolierendes Material auf.

Als elektrische isolierend werden dabei Materialen angesehen, die bei Raumtemperatur eine elektrische Leitfähigkeit **σ** von kleiner 10⁻⁸ S/m, insb. in der Größenordnung von 10⁻¹⁶ S/m haben. Insbesondere besteht der Gehäusekörper vollständig aus einem elektrisch isolierenden Material, bspw. einem Kunststoff oder einer elektrisch isolierenden Keramik. Bspw. kann der jeweilige Temperatursensor von einem Kunststoff umspritzt werden, welcher den Gehäusekörper ausbildet, wobei hierzu vorzugsweise ein Thermoplast zum Einsatz kommt. Optional könnte auch ein Gehäusekörper verwendet werden, der zumindest im Bereich des jeweiligen Auflagepunkts und ggf. zusätzlich im Bereich des jeweiligen Temperatursensors das elektrisch isolierende Material aufweist. Bei dieser Option könnte der Gehäusekörper auch teils elektrisch leitende Materialien, bspw. Stahl, aufweisen.

Dadurch, dass der Gehäusekörper ein elektrisch isolierendes Material aufweist, gelingt eine elektrische Trennung bzw. Isolation des jeweiligen Temperatursensors von der restlichen Elektronik des elektrischen Gerätes vergleichsweise einfach.

Bei einer weiteren vorteilhaften Ausgestaltung der Erfindung ist der jeweilige Temperatursensor in einem jeweiligen Hohlraum des Gehäusekörpers angeordnet. Der jeweilige Hohlraum ist somit in den Gehäusekörper integriert und kann bspw. als eine Art Schacht ausgestaltet sein. Dabei kann der jeweilige Hohlraum bzw. Schacht zu der Seite des jeweiligen Auflagepunktes hin offen sein oder zu der entgegengesetzten Seite, sodass der jeweilige Hohlraum bzw. Schacht zwar offen ist aber zur jeweiligen Auflagefläche hin geschlossen ist. Insbesondere, wenn der Gehäusekörper Wände oder Streben aufweist, ist der jeweilige Hohlraum vorzugsweise in einer der Wände oder Streben angeordnet. Das bedeutet, dass der jeweilige Hohlraum vollständig oder zumindest größtenteils von der jeweiligen Wand oder der jeweiligen Strebe umschlossen wird. Entsprechend kann der jeweilige Hohlraum geschlossen sein oder bspw. eine zur jeweiligen Platte weisende Öffnung aufweisen. Der jeweilige Temperatursensor kann beispielsweise in den jeweiligen Hohlraum gesteckt oder geklebt werden.

Durch eine derartige Ausgestaltung des Gehäusekörpers gelingt sowohl eine platzsparende Unterbringung des jeweiligen Temperatursensors als auch eine Anordnung des jeweiligen Temperatursensors am bzw. nahe der jeweiligen Platte bzw. des jeweiligen elektrischen Bauteils.

Insbesondere wenn der jeweilige Hohlraum zur jeweiligen Platte hin offen ist, kann zwischen dem jeweiligen Temperatursensor und dem Auflagepunkt bzw. der jeweiligen Platte ein gut wärmeleitendes Material, wie zum Beispiel Wärmeleitpaste, ein entsprechender Kleber oder Kunststoff angeordnet sein. Dieses gut wärmeleitende Material ist dabei vorzugsweise elektrisch isolierend, wie zum Beispiel entsprechende Keramiken oder mit einer entsprechenden Keramik gefülltes Material, Glimmer oder Wärmeleitpads. Als guter Wärmeleiter wird dabei ein Material mit einer Wärmeleitung von zumindest 40 W/(m·K), vorzugsweise größer 200 W/(m·K) oder 400 W/(m·K), angesehen.

Bei einer weiteren vorteilhaften Ausgestaltung der Erfindung weist der Gehäusekörper dabei in dem jeweiligen Hohlraum zumindest zwei Vorsprünge zur Fixierung des jeweiligen Temperatursensors auf. Durch die Vorsprünge wird der jeweilige Temperatursensor innerhalb des Gehäusekörpers positioniert und fixiert, wobei gleichzeitig eine thermische Entkopplung vom Gehäusekörper erreicht werden kann, was die Genauigkeit der Temperaturerfassung der jeweiligen Platte und somit des jeweiligen elektrischen Bauteils erhöht.

Alternativ oder zusätzlich kann der Gehäusekörper ein Material mit einer vergleichsweise schlechten Wärmeleitung aufweisen, insbesondere im Bereich um den jeweiligen Temperatursensor herum, jedoch nicht zwischen dem jeweiligen Temperatursensor und dem jeweiligen Auflagepunkt. Als vergleichsweise schlecht wärmeleitend werden dabei Materialen angesehen, die bei Raumtemperatur eine Wärmeleitfähigkeit von kleiner 0,5 W/(m·K), insb. kleiner 0,2 W/(m·K) haben.

Bei einer alternativen vorteilhaften Ausgestaltung der Erfindung ist der jeweilige Temperatursensor vollständig von dem Gehäusekörper umschlossen. Dies kann bspw. dadurch erreicht werden, dass der jeweilige Temperatursensor mit einem Kunststoff umspritzt wird, welcher den Gehäusekörper bildet. Vorzugsweise weist der Gehäusekörper ein elektrisch isolierendes Material auf, insbesondere im Bereich des jeweiligen Auflagepunktes, wodurch eine zuverlässige elektrische Trennung bzw. Isolation des jeweiligen Temperatursensors von der jeweiligen Platte bzw. dem jeweiligen elektrischen Bauteil erreicht werden kann.

Vorzugsweise weist der Gehäusekörper zwischen dem jeweiligen Temperatursensor und dem Auflagepunkt lediglich eine geringe Dicke auf. Dies kann bspw. gegeben sein, wenn der Gehäusekörper eine Größe im Bereich von Zentimetern oder Dezimetern aufweist und der jeweilige Temperatursensor einen Abstand zum jeweiligen Auflagepunkt im Bereich von Millimetern, insbesondere wenigen Millimetern, einigen Zehntel oder Hundertstel Millimeter, hat.

Alternativ oder zusätzlich kann zwischen dem jeweiligen Temperatursensor und dem Auflagepunkt bzw. der jeweiligen Platte ein gut wärmeleitendes Material, wie zum Beispiel Wärmeleitpaste, ein entsprechender Kleber oder Kunststoff angeordnet sein. Dieses gut wärmeleitende Material ist dabei vorzugsweise elektrisch isolierend, wie zum Beispiel entsprechende Keramiken oder mit einer entsprechenden Keramik gefülltes Material, Glimmer oder Wärmeleitpads.

Dieses wärmeleitende Material kann dabei als Teil des Gehäusekörpers angesehen werden oder als getrennt vom Gehäusekörper angesehen werden, wodurch eher die oben erläuterte Ausgestaltung mit einem jeweiligen Hohlraum realisiert wird und das wärmeleitende Material in dem Hohlraum zwischen dem jeweiligen Temperatursensor und der jeweiligen Platte angeordnet ist.

Bei einer weiteren vorteilhaften Ausgestaltung der Erfindung weist das Gehäuse weiterhin mehrere Anschlusspins auf, wobei der Gehäusekörper mehrere Aussparungen zur Aufnahme jeweils eines der Anschlusspins aufweist, wobei jeweils zwei benachbarte Aussparungen zueinander denselben Abstand aufweisen, und wobei der jeweilige Temperatursensor in einer der Aussparungen angeordnet ist und mit zumindest einem der Anschlusspins elektrisch verbunden ist.

Die jeweilige Aussparung kann dabei insbesondere als der jeweilige, oben erläuterte Hohlraum ausgestaltet sein. Dadurch, dass jeweils zwei benachbarte Aussparungen zueinander denselben Abstand aufweisen, können die Aussparungen gemäß einem Raster angeordnet sein. Vorzugsweise beträgt das Rastermaß 2 mm bis 5 mm, insb. 3,8 mm, sodass zwei benachbarte Aussparungen einen dem Rastermaß entsprechenden Abstand zueinander aufweisen. Der Gehäusekörper kann dabei auch zwei oder mehr Reihen solcher Aussparungen aufweisen, wobei das Rastermaß vorzugsweise innerhalb einer jeweiligen Reihe eingehalten wird, jedoch nicht notwendigerweise vom Rand der einen Reihe zum benachbarten Rand der anderen Reihe.

Die jeweiligen Aussparungen können alle oder nur zum Teil jeweils einen Anschlusspin aufweisen, der in der jeweiligen Aussparung angeordnet ist. Die Anschlusspins können bspw. zur Kontaktierung der jeweiligen Platte, insbesondere ausgestaltet als Schaltungsträger für ein Leistungsmodul oder für einen Prozessor, verwendet werden, sodass über die Anschlusspins die Versorgungsspannung, eine Erdung, und/oder Signalleitungen zur jeweiligen Platte geführt werden können. Bspw. können die Anschlusspins in den Gehäusekörper integriert, entweder in die Aussparungen gesteckt oder geklebt oder mit Kunststoff umspritzt sein.

Der jeweilige Temperatursensor ist in einer der Aussparungen angeordnet und mit dem in der entsprechenden Aussparung angeordneten Anschlusspin elektrisch verbunden. Dies ist besonders leicht realisierbar für die oben erläuterte Ausgestaltung mit einer einpoligen elektrischen Leitung zu dem jeweiligen Temperatursensor. Der jeweilige Temperatursensor kann so ausgebildet sein, dass sein einer Anschluss ein Anschlusspin des Gehäuses bzw. Gehäusekörpers ausbildet und der jeweilige Temperatursensor sich im Gehäusekörper nahe der Verbindungsfläche bzw. dem jeweiligen Auflagepunkt zur jeweiligen Platte befindet.

Die erläuterte Ausgestaltung eines gerasterten Gehäusekörpers und die erläuterte Integration jeweiligen Temperatursensors in diesen gerasterten Gehäusekörper stellt eine vergleichsweise kostengünstige Variante dar, da solche Gehäusekörper in großer Stückzahl hergestellt werden und entsprechend leicht und kostengünstig verfügbar sind.

Beispielsweise kann der jeweilige Temperatursensor sehr kostengünstig mit den gleichen Verfahren in die Gehäuse gebracht werden, wie die übrigen Anschlusspins. Insbesondere bei Lötanschlüssen können direkt die Anschlussbeine von bedrahteten Temperatursensoren verwendet werden. Die Anschlüsse können aber auch mit jeder beliebigen anderen Anschlussform versehen werden, z.B. für Einpresstechnologien, Ultraschall oder Laserschweißen, Federkontakte oder andere.

Bei einer weiteren vorteilhaften Ausgestaltung der Erfindung ist der jeweilige Temperatursensor einstückig mit dem zumindest einem Anschlusspin ausgestaltet. Dies kann bspw. dadurch erreicht werden, dass der jeweilige Temperatursensor bereits über zumindest einen entsprechenden Anschlusspin verfügt, welcher jeweils zusammen mit dem übrigen Temperatursensor in die entsprechende(n) Aussparung(en) eingebracht wird. Dadurch lässt sich eine besonders kostengünstige Montage und Herstellung des Gehäuses und somit des elektrischen Gerätes erreichen.

Bei einer weiteren vorteilhaften Ausgestaltung der Erfindung ist die jeweilige Platte als Schaltungsträger oder als Kühlkörper ausgestaltet.

Als Schaltungsträger können bspw. ein DCB-Substrat (direct bonded copper) oder ein IMS (insulated metal substrate) bzw. eine Grundplatte zum Einsatz kommen, auf welcher ein DCB-Substrat oder ein IMS angeordnet ist. Die Grundplatte kann dabei metallisch sein, bspw. aus Kupfer bestehen, oder eine Legierung aufweisen.

Alternativ kann die jeweilige Platte als Kühlkörper ausgestaltet sein, der vorzugsweise eine eher flache Oberseite aufweist und eine dieser Oberseite gegenüberliegend angeordnete Unterseite mit Kühlrippen oder Kühlpins aufweist.

Bei beiden Ausgestaltungen ist die jeweilige Platte üblicherweise mit dem während des Betriebs heißesten Punkt des elektrischen Gerätes thermisch verbunden, da das jeweilige elektrische Bauteil mit der jeweiligen Platte verbunden ist.

Indem der jeweilige Temperatursensor sehr nahe bzw. im direkten thermischen Kontakt an bzw. mit der jeweiligen Platte bzw. dem jeweiligen elektrischen Bauteil ist, kann somit die Temperatur des jeweiligen elektrischen Bauteils zuverlässig und genau bestimmt werden.

Bei einer weiteren vorteilhaften Ausgestaltung der Erfindung weist das jeweilige elektrische Bauteil zumindest ein Leistungsmodul auf, welches auf der jeweiligen Platte angeordnet ist bzw. welches die jeweilige Platte umfasst. Vorzugsweise ist die jeweilige Platte dabei als Schaltungsträger ausgebildet. Vorzugsweise umfasst das jeweilige Leistungsmodul ein oder mehrere Leistungs-Bauelemente, wie z.B. Leistungsdioden, Thyristoren, Triacs und Transistoren, wie zum Beispiel Leistungs-MOSFETs, IGBTs und dergleichen. Weiterhin kann als Leistungs-Bauelement ein elektrischer Widerstand, bspw. ein Messwiderstand, eingesetzt werden.

Bei einer weiteren vorteilhaften Ausgestaltung der Erfindung weist das jeweilige elektrische Bauteil zumindest einen Prozessor auf, welcher auf der jeweiligen Platte angeordnet ist bzw. welcher die jeweilige Platte umfasst. Vorzugsweise ist die jeweilige Platte dabei als Schaltungsträger ausgebildet. Der Prozessor kann bspw. als zentrale Verarbeitungseinheit (englisch central processing unit, kurz CPU) oder als Grafikprozessor (englisch graphics processing unit, kurz GPU) des elektrischen Gerätes ausgestaltet sein und dabei jeweils ein oder mehrere Prozessorkerne aufweisen.

Bei einer weiteren vorteilhaften Ausgestaltung der Erfindung liegt der jeweilige Temperatursensor auf der jeweiligen Platte auf und/oder ist zwischen dem jeweiligen Temperatursensor und der jeweiligen Platte ein gut wärmeleitendes Material angeordnet.

Als guter Wärmeleiter wird dabei ein Material mit einer Wärmeleitung von zumindest 40 W/(m-K), vorzugsweise größer 200 W/(m·K) oder 400 W/(m·K), angesehen. Durch diese Ausgestaltung wird ein besonders guter thermischer Kontakt des jeweiligen Temperatursensors mit der jeweiligen Platte erreicht, wie bereits weiter oben erläutert.

Bei einer weiteren vorteilhaften Ausgestaltung der Erfindung ist das elektrische Gerät als Stromrichter, Steuerung, Computer, Smartphone oder Gerät der Unterhaltungselektronik, der Gebäudeautomatisierung bzw. Smart Home oder als Haushaltsgerät ausgestaltet. Stromrichter und Steuerungen kommen dabei vor allem im industriellen Umfeld zum Einsatz, bspw. in der Fertigung und Automatisierung, wobei Stromrichter auch bei Elektrofahrzeugen (wie Elektroautos, Elektrobussen, elektrisch angetriebenen Zügen und dergleichen) oder bei der Energiewandlung und -verteilung eingesetzt werden. Computer können dabei Personal Computer, Laptops, Pads und dergleichen umfassen.

Im Folgenden wird die Erfindung anhand der in den Figuren dargestellten Ausführungsbeispiele näher beschrieben und erläutert. Es zeigen:
- FIG 1-3: ein erstes bis drittes Beispiel eines Gehäuses und des Geräts
- FIG 4-5: ein erstes und zweites Ausführungsbeispiel des vorgeschlagenen Gehäuses und des vorgeschlagenen Geräts und
- FIG 6: ein weiteres Ausführungsbeispiel des vorgeschlagenen elektrischen Gerätes.

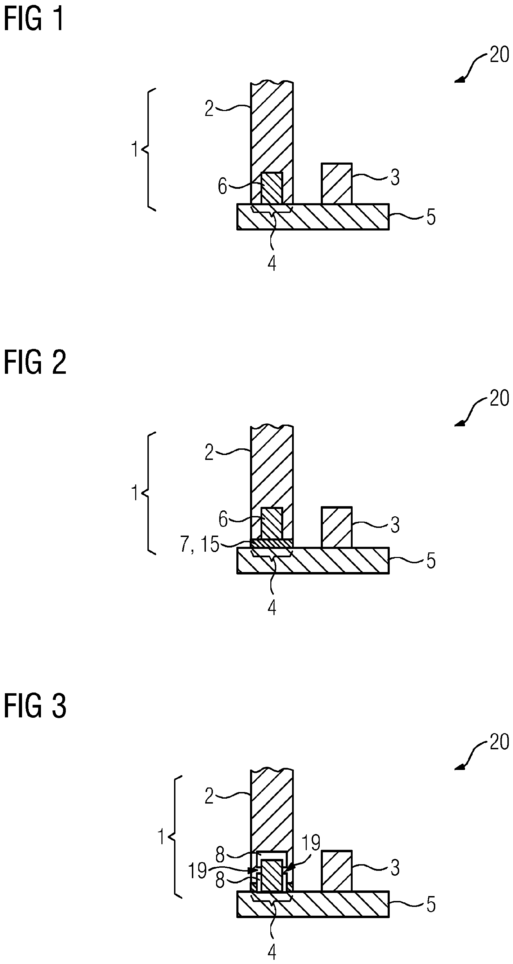

Figur 1 zeigt ein erstes Beispiel eines Gehäuses 1 und eines Geräts 20, wobei ein Querschnitt durch einen Ausschnitt des Gehäuses 1 und des Geräts 20 dargestellt ist. Das Gehäuse 1 weist ein Gehäusekörper 2 auf, welcher ein elektrisches Bauteil 3 eines elektrischen Gerätes 20 teilweise einhaust, wobei das elektrische Bauteil 3 mit einer Platte 5 des elektrischen Gerätes 20 verbunden ist. Der Gehäusekörper weist einen Auflagepunkt 4 zur Auflage auf der Platte 5 auf, wobei der Auflagepunkt 4 im Rahmen des Beispiels eine Auflagefläche ist.

Das Gehäuse 1 weist weiterhin einen Temperatursensor 6 zur Erfassung der Temperatur der Platte 5 auf. Der Temperatursensor 6 ist dabei im Gehäusekörper 2 im Bereich des Auflagepunktes 4 angeordnet.

Das elektrische Bauteil 3 und die Platte 5 sind nicht Bestandteil des Gehäuses 1, sondern Bestandteil des elektrischen Gerätes 20.

Wie in Figur 1 angedeutet, kann der Temperatursensor 6 auf der Platte 5 aufliegen bzw. diese berühren.

Figur 2 zeigt ein zweites Beispiel eines und eines Geräts 20, wobei wiederum ein Querschnitt durch einen Ausschnitt des Gehäuses 1 und des Geräts 20 dargestellt ist. Gleiche Bezugszeichen wie in Figur 1 bezeichnen dabei gleiche Gegenstände.

Der Gehäusekörper 2 weist im Bereich des jeweiligen Auflagepunktes 4 ein elektrisch isolierendes Material 7 auf. Alternativ oder zusätzlich kann im Bereich des jeweiligen Auflagepunktes 4 ein gut wärmeleitendes Material 15 angeordnet sein, welches Teil des Gehäusekörpers 2 sein kann. Ist das elektrische isolierende Material 7 bzw. das gut wärmeleitende Material 15 Teil des Gehäusekörpers 2, so ist der Temperatursensor vollständig von dem Gehäusekörper 2 umschlossen.

In einer bevorzugten Variante ist das Material, welches im Bereich des jeweiligen Auflagepunktes 4 zwischen dem Temperatursensor 6 und der Platte 5 angeordnet ist, sowohl elektrisch isolierend als auch gut wärmeleitend.

Figur 3 zeigt ein drittes Beispiel eines Gehäuses 1 und eines Geräts 20, wobei wiederum ein Querschnitt durch einen Ausschnitt des Gehäuses 1 und des Geräts 20 dargestellt ist.

Der Gehäusekörper weist einen Hohlraum 8 auf, in dem der Temperatursensor 6 angeordnet ist. Dabei weist der Gehäusekörper 2 in dem Hohlraum 8 zwei Vorsprünge 19 auf, welche den Temperatursensor 6 fixieren.

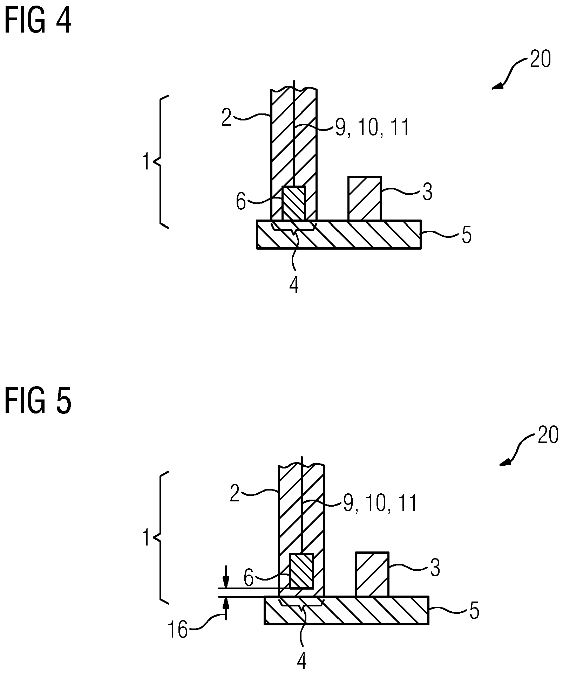

Figur 4 zeigt ein erstes Ausführungsbeispiel des vorgeschlagenen Gehäuses 1 und des vorgeschlagenen Geräts 20, wobei wiederum ein Querschnitt durch einen Ausschnitt des Gehäuses 1 und des Geräts 20 dargestellt ist.

Der Gehäusekörper 2 weist eine elektrische Leitung zu dem Temperatursensor 6 auf, wobei die elektrische Leitung als einpolige elektrische Leitung 9 ausgebildet ist. In anderen Beispielen kann die elektrische Leitung als zweipolige elektrische Leitung 10 oder dreipolige elektrische Leitung 11 ausgebildet sein.

Bei der einpoligen Variante stellt die einpolige elektrische Leitung 9 die erste Anschlussleitung für den Temperatursensor 6 bereit, wobei die zweite Anschlussleitung über einen elektrischen Kontakt des Temperatursensors 6 mit der Platte 5, die Platte 5 sowie ggf. eine Erdung oder sonstige Leitung, die mit der Platte 5 verbunden ist, verwirklicht wird.

Bei der zweipoligen Variante stellt die zweipolige elektrische Leitung 10 gemäß einer ersten Untervariante die beiden Signalleitungen des Temperatursensors 6 bereit. Diese Untervariante ist besonders vorteilhaft, wenn der Temperatursensor 6 elektrisch von der Platte getrennt bzw. isoliert ist. Gemäß einer zweiten Untervariante kann die zweipolige elektrische Leitung 10 eine der beiden Signalleitungen sowie eine Leitung für die Spannungsversorgung des Temperatursensors 6 aufweisen. Bei dieser zweiten Untervariante ist der Temperatursensor 6 vorzugsweise in elektrischem Kontakt mit der Platte, sodass die zweite Anschlussleitung über den elektrischen Kontakt des Temperatursensors 6 mit der Platte 5, die Platte 5 sowie ggf. eine Erdung oder sonstige Leitung, die mit der jeweiligen Platte verbunden ist, verwirklicht wird.

Bei der dreipoligen Variante stellt die dreipolige elektrische Leitung 11 zwei Leitungen für die Signalleitungen sowie eine Leitung für die Versorgungsspannung des Temperatursensors 6 bereit. Diese Ausgestaltung ist besonders vorteilhaft, wenn der Temperatursensor 6 von der Platte 5 elektrisch getrennt bzw. isoliert ist.

Figur 5 zeigt ein zweites Ausführungsbeispiel des vorgeschlagenen Gehäuses 1 und des vorgeschlagenen Geräts 20, wobei wiederum ein Querschnitt durch einen Ausschnitt des Gehäuses 1 und des Geräts 20 dargestellt ist.

Das zweite Ausführungsbeispiel stellt dabei eine Alternative zu dem ersten Ausführungsbeispiel dar. Der Temperatursensor 6 ist vollständig von dem Gehäusekörper 2 umschlossen, wobei der Gehäusekörper 2 jeweils eine einpolige elektrische Leitung 9 zu dem jeweiligen Temperatursensor 6 aufweist. In anderen Beispielen kann die elektrische Leitung als zweipolige elektrische Leitung 10 oder dreipolige elektrische Leitung 11 ausgebildet sein.

Bei der einpoligen Variante stellt die einpolige elektrische Leitung 9 die erste Anschlussleitung für den Temperatursensor 6 bereit, wobei die zweite Anschlussleitung über einen elektrischen Kontakt des Temperatursensors 6 mit der Platte 5, die Platte 5 sowie ggf. eine Erdung oder sonstige Leitung, die mit der jeweiligen Platte verbunden ist, verwirklicht wird. Hierzu weist der Gehäusekörper zwischen dem Temperatursensor 6 und der Auflagefläche 4 bzw. der Platte 5 ein elektrisch leitendes Material auf.

Bei der zweiten Untervariante der zweipoligen Variante stellt die zweipolige elektrische Leitung 10 eine der beiden Signalleitungen sowie eine Leitung für die Spannungsversorgung des Temperatursensors 6 bereit. Der Temperatursensor 6 ist in elektrischem Kontakt mit der Platte 5, sodass die zweite Anschlussleitung über den elektrischen Kontakt des Temperatursensors 6 mit der Platte 5, die Platte 5 sowie ggf. eine Erdung oder sonstige Leitung, die mit der jeweiligen Platte verbunden ist, verwirklicht wird. Hierzu weist der Gehäusekörper 2 zwischen dem Temperatursensor 6 und der Auflagefläche 4 bzw. der Platte 5 ein elektrisch leitendes Material auf.

Der Gehäusekörper 2 weist zwischen dem Temperatursensor 6 und dem Auflagepunkt 4 lediglich eine geringe Dicke 16 auf. Dies kann bspw. gegeben sein, wenn der Gehäusekörper 2 eine Größe im Bereich von Zentimetern oder Dezimetern aufweist und die Dicke 16 im Bereich von Millimetern, insbesondere wenigen Millimetern, einigen Zehntel oder Hundertstel Millimeter, ist.

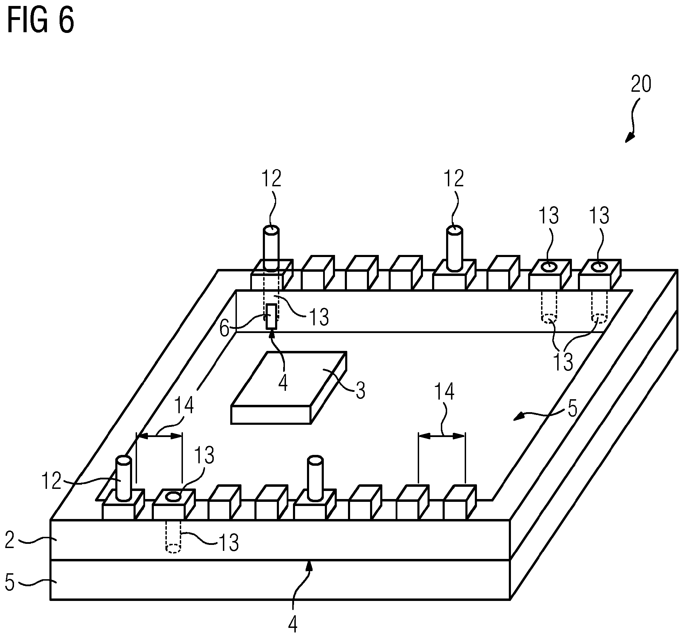

Figur 6 zeigt ein weiteres Ausführungsbeispiel des vorgeschlagenen elektrischen Gerätes 20 in einer perspektivischen Ansicht.

Der Gehäusekörper 2 ist als Gehäuserahmen ausgestaltet, der die Form eines rechteckigen Ringes aufweist. Der Gehäusekörper 2 ist dabei auf der Platte 5 angeordnet bzw. auf dieser befestigt, sodass der Gehäusekörper 2 großflächig auf der Platte 5 an einem als Auflagefläche verwirklichtem Auflagepunkt 4 aufliegt. Die Platte 5 und der Gehäusekörper 2 haben zusammen die Form einer flachen Schale, in welcher das elektrische Bauteil 3 angeordnet ist. Dabei ist das elektrische Bauteil 3 ebenfalls auf der Platte 5 angeordnet bzw. auf dieser befestigt und wird von dem Gehäusekörper umringt.

Der Gehäusekörper 2 weist mehrere Aussparungen 13 auf, in welche jeweils ein Anschlusspin 12 eingebracht werden kann. Zwei benachbarte Aussparungen 13 weisen dabei zueinander denselben Abstand 14 auf. Diese Anordnung der Aussparungen 13 gemäß einem Raster wird innerhalb der beiden dargestellten Reihen von Aussparungen 13 eingehalten, jedoch nicht zwischen Paaren von Aussparungen 13, bei welchen eine Aussparung 13 zu der einen Reihe gehört und die andere Aussparung 13 zur anderen Reihe gehört.

Der Temperatursensor 6 ist in einer der Aussparungen 13 angeordnet und mit dem in dieser Aussparungen 13 angeordneten Anschlusspin 12 elektrisch verbunden. Dazu weist der Gehäusekörper 2 jeweils eine einpolige elektrische Leitung 9 (nicht dargestellt) zu dem jeweiligen Temperatursensor 6 aufweist. Vorzugsweise ist der Temperatursensor 6 einstückig mit diesem Anschlusspin 12 ausgestaltet, so dass der Anschlusspin 12 diese einpolige elektrische Leitung 9 ausbildet.

Die Aussparungen 12 können dabei beispielsweise wie die oben erläuterten Hohlräume 8 ausgestaltet werden und insbesondere Vorsprünge 19 zur Fixierung des jeweiligen Temperartursensors 6 aufweisen.

## Patentansprüche

1. Gehäuse (1) für ein elektrisches Gerät (20) umfassend
- einen Gehäusekörper (2), welcher ein jeweiliges elektrisches Bauteil (3) des elektrischen Gerätes (20) zumindest teilweise einhaust,
wobei der Gehäusekörper (2) zumindest einen Auflagepunkt (4) zur Auflage auf einer jeweiligen Platte (5) aufweist, mit welcher das elektrische Bauteil (3) verbunden ist,
- zumindest einen Temperatursensor (6) zur Erfassung der Temperatur der jeweiligen Platte (5),
wobei der jeweilige Temperatursensor (6) im Gehäusekörper (2) im Bereich des jeweiligen Auflagepunktes (4) angeordnet ist
**dadurch gekennzeichnet, dass** der Gehäusekörper (2) jeweils eine einpolige elektrische Leitung (9) zu dem jeweiligen Temperatursensor (6) aufweist.

2. Gehäuse (1) nach Anspruch 1,
wobei der Gehäusekörper (2), vorzugsweise zumindest im Bereich des jeweiligen Auflagepunkts (4), ein elektrisch isolierendes Material (7) aufweist.

3. Gehäuse (1) nach einem der vorhergehenden Ansprüche,
wobei der jeweilige Temperatursensor (6) in einem jeweiligen Hohlraum (8) des Gehäusekörpers (2) angeordnet ist.

4. Gehäuse (1) nach Anspruch 3,
wobei der Gehäusekörper (2) in dem jeweiligen Hohlraum (8) zumindest zwei Vorsprünge (19) zur Fixierung des jeweiligen Temperatursensors (6) aufweist.

5. Gehäuse (1) nach einem der vorhergehenden Ansprüche,
wobei der jeweilige Temperatursensor (6) vollständig von dem Gehäusekörper (2) umschlossen ist.

6. Gehäuse (1) nach einem der vorhergehenden Ansprüche, weiterhin aufweisend mehrere Anschlusspins (12),
wobei der Gehäusekörper (2) mehrere Aussparungen (13) zur Aufnahme jeweils eines der Anschlusspins aufweist,
wobei jeweils zwei benachbarte Aussparungen (13) zueinander denselben Abstand (14) aufweisen, und
wobei der jeweilige Temperatursensor (6) in einer der Aussparungen (13) angeordnet ist und mit zumindest einem der Anschlusspins (12) elektrisch verbunden ist.

7. Gehäuse (1) nach Anspruch 6,
wobei der jeweilige Temperatursensor (6) einstückig mit dem zumindest einem Anschlusspin (12) ausgestaltet ist.

8. Elektrisches Gerät (20) umfassend
- zumindest ein elektrisches Bauteil (3),
- zumindest eine Platte (5), die jeweils mit dem jeweiligen elektrischen Bauteil (3) verbunden ist, und
- zumindest ein Gehäuse (1) nach einem der vorhergehenden Ansprüche,
wobei der Gehäusekörper (2) an dem jeweiligen Auflagepunkt (4) auf der jeweiligen Platte (5) aufliegt,
**dadurch gekennzeichnet, dass** der Gehäusekörper (2) jeweils eine einpolige elektrische Leitung (9) zu dem jeweiligen Temperatursensor (6) aufweist.

9. Elektrisches Gerät (20) nach Anspruch 8,
wobei die jeweilige Platte (5) als Schaltungsträger oder als Kühlkörper ausgestaltet ist.

10. Elektrisches Gerät (20) nach Anspruch 8 oder 9,
wobei das jeweilige elektrische Bauteil (3) zumindest ein Leistungsmodul aufweist, welches auf der jeweiligen Platte (5) angeordnet ist bzw. welches die jeweilige Platte (5) umfasst.

11. Elektrisches Gerät (20) nach einem der Ansprüche 8 bis 10,
wobei das jeweilige elektrische Bauteil (3) zumindest einen Prozessor aufweist, welcher auf der jeweiligen Platte (5) angeordnet ist bzw. welcher die jeweilige Platte (5) umfasst.

12. Elektrisches Gerät (20) nach einem der Ansprüche 8 bis 11,
wobei der jeweilige Temperatursensor (6) auf der jeweiligen Platte (5) aufliegt und/oder
wobei zwischen dem jeweiligen Temperatursensor (6) und der jeweiligen Platte (5) ein gut wärmeleitendes Material (15) angeordnet ist.

13. Elektrisches Gerät (20) nach einem der Ansprüche 8 bis 12,
wobei das elektrische Gerät (20) als Stromrichter, Steuerung, Computer, Smartphone oder Gerät der Unterhaltungselektronik, der Gebäudeautomatisierung bzw. Smart Home oder als Haushaltsgerät ausgestaltet ist.

## Claims

1. Housing (1) for an electrical appliance (20) comprising
- a housing body (2), which at least partially houses a respective electrical component (3) of the electrical appliance (20),
wherein the housing body (2) has at least one support point (4) for being supported on a respective plate (5) to which the electrical component (3) is connected,
- at least one temperature sensor (6) for sensing the temperature of the respective plate (5),
wherein the respective temperature sensor (6) in the housing body (2) is arranged in the region of the respective support point (4),
**characterised in that** the housing body (2) in each case has a single-pole electrical line (9) to the respective temperature sensor (6).

2. Housing (1) according to claim 1,
wherein the housing body (2) has an electrically insulating material (7), preferably at least in the region of the respective support point (4).

3. Housing (1) according to one of the preceding claims,
wherein the respective temperature sensor (6) is arranged in a respective cavity (8) of the housing body (2).

4. Housing (1) according to claim 3,
wherein the housing body (2) has at least two projections (19) in the respective cavity (8) for fixing the respective temperature sensor (6).

5. Housing (1) according to one of the preceding claims, wherein the respective temperature sensor (6) is completely enclosed by the housing body (2).

6. Housing (1) according to one of the preceding claims, furthermore having a plurality of connecting pins (12),
wherein the housing body (2) has a plurality of recesses (13) for receiving one of the connecting pins in each case,
wherein in each case two adjacent recesses (13) have the same distance to one another (14), and
wherein the respective temperature sensor (6) is arranged in one of the recesses (13) and is electrically connected to at least one of the connecting pins (12).

7. Housing (1) according to claim 6,
wherein the respective temperature sensor (6) is embodied in one piece with the at least one connecting pin (12).

8. Electrical appliance (20) comprising
- at least one electrical component (3),
- at least one plate (5) connected in each case to the respective electrical component (3), and
- at least one housing (1) according to one of the preceding claims,
wherein the housing body (2) is supported on the respective plate (5) at the respective support point (4),
**characterised in that** the housing body (2) in each case has a single-pole electrical line (9) to the respective temperature sensor (6).

9. Electrical appliance (20) according to claim 8,
wherein the respective plate (5) is embodied as a circuit carrier or as a heat sink.

10. Electrical appliance (20) according to claim 8 or 9, wherein the respective electrical component (3) has at least one power module arranged on the respective plate (5) or comprising the respective plate (5).

11. Electrical appliance (20) according to one of claims 8 to 10,
wherein the respective electrical component (3) has at least one processor arranged on the respective plate (5) or comprising the respective plate (5).

12. Electrical appliance (20) according to one of claims 8 to 11,
wherein the respective temperature sensor (6) is supported on the respective plate (5) and/or
wherein a material with good thermal conductivity (15) is arranged between the respective temperature sensor (6) and the respective plate (5).

13. Electrical appliance (20) according to one of claims 8 to 12,
wherein the electrical appliance (20) is embodied as a power converter, controller, computer, smartphone or appliance for consumer electronics, building automation or smart home, or as a household appliance.

## Revendications

1. Boîtier (1) d'un appareil (20) électrique, comprenant
- un corps (2) de boîtier, dans lequel est logé au moins en partie un composant (3) électrique respectif de l'appareil (20) électrique,
dans lequel le corps (2) du boîtier a au moins un point (4) d'appui pour l'appui sur une plaque (5) respective, à laquelle le composant (3) électrique est relié,
- au moins une sonde (6) de température pour la détection de la température de la plaque (5) respective,
dans lequel la sonde (6) de température respective dans le corps (2) du boîtier est disposée dans la partie du point (4) d'appui respectif,
**caractérisé en ce que** le corps (2) du boîtier a respectivement une ligne (9) électrique monopolaire allant à la sonde (6) de température respective.

2. Boîtier (1) suivant la revendication 1,
dans lequel le corps (2) du boîtier a, de préférence au moins dans la partie du point (4) d'appui respectif, un matériau (7) isolant électriquement.

3. Boîtier (1) suivant l'une des revendications précédentes, dans lequel la sonde (6) de température respective est disposée dans une cavité (8) respective du corps (2) du boîtier.

4. Boîtier (1) suivant la revendication 3,
dans lequel le corps (2) du boîtier a dans la cavité (8) respective au moins deux saillies (19) de fixation de la sonde (6) de température respective.

5. Boîtier (1) suivant l'une des revendications précédentes, dans lequel la sonde (6) de température respective est enveloppée complètement par le corps (2) du boîtier.

6. Boîtier (1) suivant l'une des revendications précédentes, comportant en outre plusieurs broches (12) de connexion, dans lequel le corps (2) du boîtier a plusieurs évidements (13) de réception respectivement de broches de connexion,
dans lequel respectivement deux évidements (13) voisins sont à distance (14) l'un de l'autre et
dans lequel la sonde (6) de température respective est disposée dans l'un des évidements (13) et est reliée électriquement à au moins l'une des broches (12) de connexion.

7. Boîtier (1) suivant la revendication 6,
dans lequel la sonde (6) de température respective est d'une seule pièce avec la au moins une broche (12) de connexion.

8. Appareil (20) électrique comprenant
- au moins un composant (3) électrique,
- au moins une plaque (5), qui est reliée respectivement au composant (3) électrique respectif, et
- au moins un boîtier (1) suivant l'une des revendications précédentes,
dans lequel le corps (2) du boîtier s'appuie au point (4) d'appui respectif sur la plaque (5) respective,
**caractérisé en ce que** le corps (2) du boîtier a respectivement une ligne (9) électrique monopolaire allant à la sonde (6) de température respective.

9. Appareil (20) électrique suivant la revendication 8,
dans lequel la plaque (5) respective est conformée en support du circuit ou en puits de chaleur.

10. Appareil (20) électrique suivant la revendication 8 ou 9, dans lequel le composant (3) électrique respectif a au moins un module de puissance, qui est disposé sur la plaque (5) respective ou qui entoure la plaque (5) respective.

11. Appareil (20) électrique suivant l'une des revendications 8 à 10,
dans lequel le composant (3) électrique respectif a au moins un processeur, qui est disposé sur la plaque (5) respective ou qui entoure la plaque (5) respective.

12. Appareil (20) électrique suivant l'une des revendications 8 à 11,
dans lequel la sonde (6) de température respective s'appuie sur la plaque (5) respective et/ou
dans lequel un matériau (15) bon conducteur de la chaleur est disposé entre la sonde (6) de température respective et la plaque (5) respective.

13. Appareil (20) électrique suivant l'une des revendications 8 à 12,
dans lequel l'appareil (20) électrique est conformé en convertisseur, commande, ordinateur, téléphone intelligent ou appareil de l'électronique de divertissement, de l'automatisation des bâtiments ou en smart home ou en appareil électroménager.
